# EUROPÄISCHE PATENTANMELDUNG

(11) **EP 4 766 084 A1**
(43) Veröffentlichungstag der Anmeldung: **24.06.2026**
(21) Anmeldenummer: 25225051.9
(22) Anmeldetag: 18.12.2025
(51) Int. Cl.: H10D 48/01, H10D 48/00, H10D 62/83, B82Y 10/00

(54) **SPIN-INFORMATIONS-TRANSPORTVORRICHTUNG UNTER VERWENDUNG EINER KETTE AUS 13C-ATOMEN UND VERFAHREN ZUR HERSTELLUNG**

(30) Priorität: 20.12.2024 DE 102024139460
(71) Anmelder: Deutsches Zentrum für Luft- und Raumfahrt e.V., 53227 Bonn (DE)
(72) Erfinder: Findler, Christoph, 53227 Bonn (DE); Lang, Johannes, 53227 Bonn (DE); Osterkamp, Christian, 53227 Bonn (DE)
(74) Vertreter: noventive Patentanwaltsgesellschaft mbH

(57) **Zusammenfassung**

Die vorliegende Erfindung betrifft eine Spin-Informations-Transportvorrichtung (1), welche eine Diamantmatrix (3) aus angereichertem C12-Diamant und zwei Fehlstellen-Zentren (4), insbesondere NV-Zentren, innerhalb der Diamantmatrix 3 umfasst, wobei sich ein Spinpolarisationskanal (6) aus C13 angereichertem Diamant, zur Ermöglichung einer gerichteten Ausbreitung einer Spinpolarisation zwischen den zwei Fehlstellen-Zentren (4) erstreckt. Einen weiteren Gegenstand der Erfindung bildet ein Verfahren zur Herstellung einer solchen Spin-Informations-Transportvorrichtung (1).

## Beschreibung

Die vorliegende Erfindung betrifft eine Spin-Informations-Transportvorrichtung, welche eine Diamantmatrix aus C12-Diamant und zwei Fehlstellen-Zentren, insbesondere NV-Zentren, innerhalb der Diamantmatrix umfasst. Einen weiteren Gegenstand der Erfindung bildet ein Verfahren zur Herstellung einer solchen Spin-Informations-Transportvorrichtung.

Die Herstellung synthetischer Diamanten mittels CVD (chemischer Gasphasenabscheidung) ist eine gebräuchliche Technik zur Herstellung synthetischer Diamanten in der Industrie. Der Fokus liegt dabei insbesondere auf dem Wachstum von Diamantschichten, die eine Dicke über 100 nm besitzen und überwiegend für Anwendungen in der Schmuckindustrie sowie für die Materialbearbeitung, z. B. als Schneidwerkzeuge, hergestellt werden. Bei diesen Anwendungen sind lediglich die mechanischen Eigenschaften der erzeugten Diamanten relevant, wie z. B. die Härte.

Seit neustem gewinnen synthetische Diamanten auch für Hochtechnologie-Anwendungen zunehmende Relevanz, wie z.B. in der Quantentechnologie oder Halbleitertechnologie. In der Quantentechnologie wird Diamant als Matrix genutzt, in welche atomare Fehlstellen-Zentren eingebracht werden, wie beispielsweise NV-(Stickstoff-Fehlstellen-Zentren), SiV- (Silizium-Fehlstellen-Zentren), GeV-(Germanium-Fehlstellen-Zentren) oder SnV-Zentren (Zinn-Fehlstellen-Zentren).

Um die Fehlstellen-Zentren zum Beispiel für das Quantencomputing nutzbar zu machen, werden diese in eine mit dem Isotop Kohlenstoff-13 (C13), welches im Gegensatz zum Isotop Kohlenstoff-12 (C12) einen von Null verschiedenen Kernspin aufweist, angereicherte Matrix eingebracht. Ist der Abstand zwischen einem Fehlstellen-Zentrum und einem C13-Atom gering genug, so tritt eine messbare Kopplung zwischen den Spins des Fehlstellen-Zentrums und des C13-Atoms auf, so dass diese als Qubits genutzt werden können.

Die Fehlstellen-Zentren liegen dabei in der Schicht aus C13 angereichertem Diamant. Sofern diese eine ausreichende Dichte an C13-Atomen und damit an C13-Kernspins aufweist, kann sich die Spinpolarisation in beliebigen Richtungen innerhalb der gesamten Diamantschicht ausbreiten. Eine gerichtete Ausbreitung von Spinpolarisationen, welche als Spin-Information durch Quantenmanipulation der Fehlstellen-Zentren erzeugt werden, innerhalb des Diamantmaterials ist mit diesen Diamantstrukturen daher jedoch nicht möglich. Solche gerichteten Ausbreitungen wären jedoch zur Erzeugung komplexerer quantenmechanischer Schaltungselemente erforderlich.

Die Aufgabe der vorliegenden Erfindung liegt daher darin, eine Vorrichtung bereitzustellen, aus welcher auch komplexere quantenmechanische Schaltungselemente aufgebaut werden können.

Diese Aufgabe wird bei einer Vorrichtung der eingangs genannten Art durch einen Spinpolarisationskanal, insbesondere aus C13 angereichertem Diamant, zur Ermöglichung einer gerichteten Ausbreitung einer Spinpolarisation gelöst, welcher sich zwischen den zwei Fehlstellen-Zentren erstreckt, insbesondere die zwei Fehlstellen-Zentren miteinander verbindet.

Mittels des Spinpolarisationskanals kann eine gerichtete Polarisationsdiffusion zwischen den atomare Fehlstellen-Zentren ermöglicht werden. Der Spinpolarisationskanal, insbesondere aus C13 angereichertem synthetischen Diamant, kann die Ausbreitungsmöglichkeiten der Spinpolarisation im Wesentlichen auf eine eindimensionale Ausbreitung beschränken. Die eindimensionale Ausbreitung (Diffusion) der (Kern-)Spinpolarisation kann auf diese Weise gerichtet entlang der Längsachse des Spinpolarisationskanals erfolgen.

Die, insbesondere synthetische, Diamantmatrix aus C12-Diamant kann eine kernspinfreie Schicht bereitstellen, in welcher keine Ausbreitung der Spinpolarisation möglich ist, so dass der Spinpolarisationskanal in der Diamantmatrix nicht umgangen werden kann.

Mittels des Spinpolarisationskanals kann die Spin-Informations-Transportvorrichtung Quanteninformationen von einem Fehlstellen-Zentrum zum anderen transportieren. Insbesondere kann die Möglichkeit eröffnet werden, durch die Verwendung mehrere Spin-Informations-Transportvorrichtungen komplexerer quantenmechanischer Schaltungselemente aufzubauen und beispielsweise Quantentransistoren zu erzeugen und zu einem Netzwerk, einem Qubit-Register, kohärent zu verbinden.

Der Spinpolarisationskanal kann eine sehr hohe Anreicherung mit C13 aufweisen. Insbesondere sind Anreicherungen mit C13 im Bereich 10 % bis 99,99%, vorzugsweise im Bereich 50% bis 99,99%, möglich. Mit einer derart hohen Anreicherung mit C13 kann einen effizienten Polarisationsdiffusion, d.h. einen Spintransport, im Spinpolarisationskanal sichergestellt werden.

Bei den atomare Fehlstellen-Zentren kann es sich um NV-Zentren (Stickstoff-Fehlstellen-Zentren), SiV-Zentren (Silizium-Fehlstellen-Zentren), GeV-Zentren (Germanium-Fehlstellen-Zentren) und/oder SnV-Zentren (Zinn-Fehlstellen-Zentren) handeln.

Bevorzugt ist der Spinpolarisationskanal oberhalb der Fehlstellen-Zentren angeordnet. Durch die Anordnung des Spinpolarisationskanals oberhalb der Fehlstellen-Zentren kann die gerichtete Ausbreitung der Spinpolarisation in einer anderen Ebene als die Erzeugung der Spinpolarisation durch Quantenmanipulation der Fehlstellen-Zentren erfolgen. Insbesondere kann die gerichtete Ausbreitung der Spinpolarisation in einer Schicht mit einer anderen chemischen Zusammensetzung als die Schicht, in welcher die Fehlstellen-Zentren angeordnet sind, erfolgen.

"Oberhalb" bezieht sich dabei auf eine Anordnung auf der vom Inneren der Diamantmatrix wegweisenden, insbesondere von einem Substrat wegeweisenden, Seite der Fehlstellen-Zentren. Insbesondere kann sich "oberhalb" allgemein auf eine Anordnung entlang einer Wachstumsrichtung beziehen.

Der Spinpolarisationskanal kann derart oberhalb der Fehlstellen-Zentren angeordnet sein, dass unterhalb der diametral gegenüberliegenden Enden des Spinpolarisationskanals jeweils ein Fehlstellen-Zentrum angeordnet ist.

Weiter vorteilhaft ist es, wenn der Spinpolarisationskanal von einer C12-Diamantschutzschicht überdeckt ist. Mit der, insbesondere reinen, C12-Diamantschutzschicht kann der Spinpolarisationskanal auf der von der Diamantmatrix abgewandten Seite geschützt werden. Durch die Verwendung des kernspinlosen C12 in der Diamantschutzschicht kann zum Schutz vor Spin-Noise eine Spin-Abschirmung des Spinpolarisationskanals nach vorrichtungsaußen erzielt werden. Die C12-Diamantschutzschicht kann insbesondere eine Dicke von mindestens 50 nm, bevorzugt mindestens 100 nm, aufweisen.

Gemäß einer konstruktiven Ausgestaltung ist die Diamantmatrix auf einem Diamantsubstrat angeordnet. Das Diamantsubstrat kann ein mechanisch und chemisch stabiles Substrat für die Diamantmatrix bilden. Die Diamantmatrix kann chemisch mit dem Diamantsubstrat verbunden, insbesondere auf diesem aufgewachsen, sein.

Es ist möglich, dass die zwei Fehlstellen-Zentren einen Abstand von 5 nm bis 100 µm, insbesondere von 500 nm bis 1 µm, aufweisen. Auf diese Weise kann eine Spinpolarisation zwischen zwei für quantenmechanische Anwendungen weit entfernte Punkte übertragen werden.

Ferner ist es möglich, dass der Spinpolarisationskanal eine Breite von 1 nm bis 10 µm, bevorzugt im Bereich von 5 nm bis 100 nm, und/oder eine Länge von mindestens 5 nm, bevorzugt mindestens 500 nm, insbesondere bevorzugt im Bereich von 500 nm bis 1 µm, ferner bevorzugt im Bereich von 1 µm bis 5 µm, und/oder eine Dicke im Bereich von 0,5 nm bis 100 nm, vorzugsweise 1 nm bis 10 nm, aufweist. Mit einem Spinpolarisationskanal dieser Länge kann eine Spinpolarisation über eine für quantenmechanische Anwendungen weite Strecke gerichtet übertragen werden. Mit einem Spinpolarisationskanal dieser Breite und/oder Dicke, welche quer zur Ebene der Diamantmatrix gemessen wird, können die Ausbreitungsmöglichkeiten der Spinpolarisation im Spinpolarisationskanal auf einfache Weise auf eine eindimensionale Ausbreitung entlang der Länge des Spinpolarisationskanals beschränkt werden.

Weiter vorteilhaft kann es sein, wenn die Diamantmatrix eine Dicke von mindestens 50 nm, insbesondere mindestens 100 nm, aufweist. Auf diese Weise kann die Diamantmatrix eine mechanisch stabile Schicht zur Aufnahme der Fehlstellen-Zentren bereitstellen.

Bei einem Verfahren der eingangs genannten Art wird zur Lösung der vorstehend genannten Aufgabe vorgeschlagen, dass es die Schritte des Aufwachsens einer Diamantmatrix aus C12 angereichertem Diamant auf ein, insbesondere ultrareines, Diamantsubstrat mittels CVD, der Einbringung von Fehlstellen-Zentren in die Diamantmatrix, des Aufwachsens einer C13 angereicherten Diamantschicht und des bereichsweisen Abtragens der C13 angereicherten Diamantschicht, insbesondere durch Ätzen, zur Formung eines Spinpolarisationskanals umfasst.

Mittels des Verfahrens kann eine erfindungsgemäße Spin-Informations-Transportvorrichtung mit einem Spinpolarisationskanal hergestellt werden, der eine gerichtete Polarisationsdiffusion zwischen den Fehlstellen-Zentren ermöglichen kann. Die in Zusammenhang mit der erfindungsgemäßen Spin-Informations-Transportvorrichtung beschriebenen Merkmale können einzeln oder in Kombination auch bei dem Verfahren zur Anwendung kommen. Es ergeben sich die gleichen Vorteile, welche bereits beschrieben wurden.

Insbesondere durch das Aufwachsen einer Diamantmatrix aus C12 angereichertem Diamant auf ein ultrareines Diamantsubstrat mittels CVD kann ein unerwünschter Eintrag von Fremdatomen, d. h. Nicht-Kohlenstoffatomen, aus dem Diamantsubstrat in die Diamantmatrix während weiterer Verarbeitungsschritte verhindert werden. Ein ultrareines Diamantsubstrat kann eine durch die Herstellung des Diamantsubstrats in diesem verbleibende Reststickstoffkonzentration von unter 5 ppb (parts per billion) aufweisen.

Die Diamantmatrix kann eine Dicke, gemessen entlang ihrer Wachstumsrichtung auf dem Diamantsubstrat, von mindestens 50 µm, insbesondere mindestens 100 µm, aufweisen.

Durch das Aufwachsen mittels CVD kann auf einfache Art und Weise eine Diamantmatrix auf dem Diamantsubstrat erzeugt werden, welche mit 12C angereichert ist, insbesondere aus C12 besteht. Die Diamantmatrix aus C12 angereichertem Diamant kann eine kernspinfreie Schicht bereitstellen, in welche die Fehlstellen-Zentren eingebracht werden können. Eine Ausbreitung der Spinpolarisation in der Diamantmatrix und somit ein Umgehen des Spinpolarisationskanals kann auf diese Weise verhindert werden.

Zum Aufwachsen der Diamantmatrix mittels CVD kann ein C12-angereichertes Methangas genutzt werden.

Zum Einbringen der Fehlstellen-Zentren kann eine Ionenimplantation in die Diamantmatrix erfolgen. Bei der Ionenimplantation können Ionen, z.B. im Falle von NV-Zentren Stickstoff-Ionen, auf die Diamantmatrix beschleunigt werden. Die Ionen können in einer von der Beschleunigungs-Energie abhängigen Tiefe in der Diamantmatrix zur Ruhe kommen, wobei sie auf ihrem Weg Fehlstellen erzeugen. Durch einen nachgelagerten Ausheizprozess können sich die Ionen und Fehlstellen zu den Fehlstellen-Zentren verbinden, z. B.im Fall von ionenimplementiertem Stickstoff zu NV-Zentren. Die Ionenimplantation kann insbesondere mittels Stickstoff-15-Ionen (15N+) einer Energie von 0,1 keV bis 5 keV, vorzugsweise 1 keV, und/oder einer von Dosis von mindestens 10¹¹ 15N+/cm erfolgen.

Die Ionenimplantation kann kontrolliert erfolgen, insbesondere durch Nutzung einer Maske, welche die Diamantmatrix abdeckt und eine Ionenimplantation nur in einigen vordefinierten Bereichen der Diamantmatrix zulässt.

Die Ionenimplantation kann derart erfolgen, dass die Fehlstellen-Zentren unterhalb der vorgegebenen Enden des Spinpolarisationskanals erzeugt werden.

Durch das Aufwachsen der C13 angereicherten Diamantschicht kann eine C13-Kernspins enthaltende Diamantschicht auf der, insbesondere von C13-Kernspins freien, Diamantmatrix erzeugt werden. Die C13 angereicherte Diamantschicht kann neben C13 auch C12 aufweisen, insbesondere überwiegend C12 umfassen. Die C13 angereicherte Diamantschicht kann, insbesondere unmittelbar, auf der Diamantmatrix aufgewachsen werden. Die C13 angereicherte Diamantschickt kann eine Dicke im Bereich von 0,5 nm bis 100 nm, vorzugsweise 1 nm bis 10 nm, aufweisen. Bei dem Aufwachsen der Diamantschicht kann eine sehr geringe Wachstumsrate, welche unterhalb der normalerweise üblichen Wachstumsraten liegt, verwendet wird, um eine nm-genaue Einstellung der Schichtdicke zu ermöglichen.

Durch das bereichsweise Abtragen der C13 angereicherten Diamantschicht kann der Spinpolarisationskanal auf einfache Weise ausgeformt werden, ohne dass die Diamantmatrix verändert wird. Das bereichsweise Abtragen der C13 angereicherten Diamantschicht kann derart erfolgen, dass die C13 angereicherte Diamantschicht in einzelnen, insbesondere in nicht einen Spinpolarisationskanal bildenden, Bereichen vollständig abgetragen wird. Insbesondere durch Ätzen kann die C13 angereicherte Diamantschicht auf einfache Weise bereichsweise abgetragen werden. Dabei kann ein lithographisches Ätzverfahren angewandt werden. Bei diesem kann der Bereich der Diamantschicht, welcher den Spinpolarisationskanal formen soll, mittels einer Maske abgedeckt werden, so dass nur die nicht durch die Maske abgedeckten Bereiche der C13 angereicherten Diamantschicht abgeätzt werden. Die Maske kann als ein Fotolack auf die C13 angereicherte Diamantschicht aufgebracht werden.

Nachfolgend kann die bereichsweise mit dem Fotolack beschichtete C13 angereicherte Diamantschicht belichtet werden, wodurch das selektive Ätzen ermöglicht wird.

Es kann vorgesehen sein, dass auf den Spinpolarisationskanal eine C12-Diamantschutzschicht zur Steigerung der Kohärenzzeit der Fehlstellen-Zentren aufgewachsen wird. Die C12-Diamantschutzschicht kann den Spinpolarisationskanal vor negativen Einflüssen von der Oberfläche der Spin-Informations-Transportvorrichtung schützen. Dabei kann die C12-Diamantschutzschicht ultrarein, d.h. eine C12-Anreicherung von im Wesentlichen 99,9% aufweisend, insbesondere C13-frei, ausgestaltet sein. Durch die Verwendung des kernspinlosen C12 in der Diamantschutzschicht kann zum Schutz vor Spin-Noise eine Spin-Abschirmung des Spinpolarisationskanals nach vorrichtungsaußen erzielt werden.

Die C12-Diamantschutzschicht kann insbesondere in einer Dicke von mindestens 50 nm, bevorzugt mindestens 100 nm, aufgewachsen werden.

In vorteilhafter Weise kann das Aufwachsen der C13 angereicherten Diamantschicht mittels CVD unter Nutzung von C13-angereichertem Methangas erfolgen. Die Anreicherung der Diamantschicht mit C13 kann auf einfache Weise durch ein Wachstum des Diamanten mit C13 angereichertem Wachstumsgas, insbesondere Methangas, erzielt werden. Dabei kann anhand der Höhe der Anreicherung des Wachstumsgases mit C13 die Dichte der C13-Kernspins in der gewachsenen synthetischen Diamantschicht eingestellt werden.

Ferner kann es vorteilhaft sein, wenn zum Einbringen von Fehlstellen-Zentren in die Diamantmatrix eine Ionenimplantation und anschließend ein Hochtemperatur-Ausheizen erfolgt, insbesondere in einem Vakuum. Durch die Ionenimplantation und das anschließende Hochtemperatur-Ausheizen können Ionen in die Diamantmatrix eingebracht und sich anschließend beim Hochtemperatur-Ausheizen mit den Fehlstellen zu den Fehlstellen-Zentren verbinden. Das Hochtemperatur-Ausheizen kann insbesondere bei einer Temperatur von 1000 °C für 3 Stunden in Vakuum erfolgen, bevorzugt bei einem Druck unterhalb von 10⁻⁷ mbar.

Vorzugsweise erfolgt das bereichsweise Abtragen der C13 angereicherten Diamantschicht mittels eines kontrollierten Plasmaätzens, insbesondere ICP, der Oberfläche der C13 angereicherten Diamantschicht. Mittels eines kontrollierten Plasmaätzens kann Diamantmaterial von der Oberfläche der C13 angereicherten Diamantschicht kontrolliert mit einer Genauigkeit im Nanometerbereich entfernt werden. Das kontrollierte Plasmaätzen kann durch induktives Plasmaätzen (ICP) oder reaktives Ionenätzen (RIE) erzielt werden. Das induktive Plasmaätzen kann durch Zünden eines induktiv gekoppelten Plasmas, insbesondere eines Sauerstoff-Plasmas oder eines Ar/SF6-Palsmas (SF6: Schwefelhexafluorid), und Anlegen einer die reaktiven Ionen auf die Diamantschicht beschleunigende Beschleunigungsspannung erzielt werden.

Weitere Einzelheiten und Vorteile eine erfindungsgemäßen Spin-Informations-Transportvorrichtung sowie eines erfindungsgemäßen Verfahrens sollen nachfolgend anhand eines in der Figur schematisch dargestellten Ausführungsbeispiels der Erfindung exemplarisch erläutert werden. Darin zeigt:

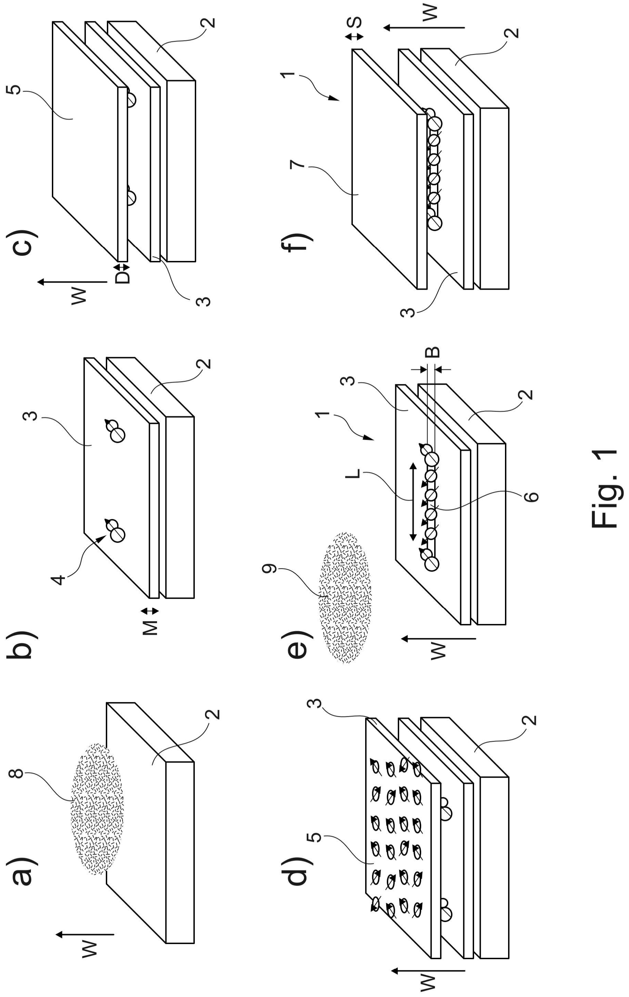

- Fig. 1a-f: Die einzelnen Schritte eines erfindungsgemäßen Herstellungsverfahrens sowie eine erfindungsgemäße Spin-Informations-Transportvorrichtung.

Zu besseren Kenntlichmachung der einzelnen Schichten sind diese in dem Teilfiguren (Fig. 1a bis Fig. 1f) beabstandet zueinander dargestellt. In der Spin-Informations-Transportvorrichtung 1 und während der Herstellung dieser liegen diese Schichten jedoch derart abstandslos aufeinander, dass sie in Wachstumsrichtung W aneinander anschließen.

In Fig. 1a wird der erste Schritt der Herstellung der Spin-Informations-Transportvorrichtung 1 gezeigt. Auf ein reines Diamantsubstrat 2 wird mittels CVD eine Diamantmatrix 3 aufgewachsen. Während des CVD-Wachstums wird ein C12 haltiges Wachstumsgas 8 genutzt. Zum Wachstum der Diamantmatrix 3 ist dieses Wachstumsgas 8 C13-frei, so dass die Diamantmatrix 3 nach Abschluss des Wachstums kernspinlos ist. Als Wachstumsgas 8 kann Methangas genutzt werden.

Entlang der Wachstumsrichtung W entsteht auf diese Weise eine Diamantmatrix 3 auf dem Diamantsubstrat 2. Diese Diamantmatrix 3 hat eine Dicke M von mindestens 50 nm bis 100 nm. Sie ist damit ausreichend dick, um die im nachfolgenden Schritt eingebrachten Fehlstellen-Zentren 4 aufnehmen zu können, ohne dass diese bis in das Diamantsubstrat 2 vordringen.

Nach dem Aufwachsen der Diamantmatrix 3 werden die Fehlstellen-Zentren 4 in die Diamantmatrix 3 eingebracht, wie in Fig. 1b dargestellt.

Zum Einbringen der Fehlstellen-Zentren 4 in die Diamantmatrix 3 erfolgt zunächst eine Ionenimplantation. Bei dieser werden beispielsweise Stickstoff-15-lonen (15N+) einer Energie von 1 keV und mit einer Dosis von 10¹¹ 15N+/cm auf die Diamantmatrix 3 beschleunigt. In einer von der von der Beschleunigungs-Energie abhängigen Tiefe kommen die Ionen dann in der Diamantmatrix 3 zur Ruhe. Auf dem Weg zu dieser Ruheposition erzeugen die Ionen beim Durchqueren des Materials der Diamantmatrix 3 Fehlstellen in der Diamantmatrix 3.

Um die Ionen gezielt in die Diamantmatrix 3 einzubringen, wird diese zuvor maskiert. Bei dieser Maskierung werden lediglich jene Bereiche auf der Oberfläche der Diamantmatrix 3 freigelassen, in denen sich später die Fehlstellen-Zentren 4 befinden sollen. Die bei der Ionenimplantation nicht-maskierten Bereiche können z.B. Abstände von ca. 5 nm bis 100 µm zueinander aufweisen, so dass zwei Fehlstellen-Zentren 4 in der späteren Spin-Informations-Transportvorrichtung 1 in einem Abstand von ca. 5 nm bis 100 µm zueinander angeordnet sind.

Anschließend an die Ionenimplantation erfolgt ein Hochtemperatur-Ausheizen des Systems aus Diamantsubstrat 2 und Diamantmatrix 3. Dieses Hochtemperatur-Ausheizen erfolgt bei einem Druck von unter 10⁻⁷ mbar in einem Vakuum, um unerwünschte chemische Reaktionen ausschließen zu können. Dabei wird das System für drei Stunden auf eine Temperatur von über 1000 °C erhitzt. Bei diesen Temperaturen können sich die in die Diamantmatrix 3 implementierten Ionen und Fehlstellen zu den Fehlstellen-Zentren 4 verbinden. So werden beispielsweise durch eine Implantation von Stickstoff-15-Ionen und das anschließende Hochtemperatur-Ausheizen NV-Zentren als Fehlstellen-Zentren 4 in die Diamantmatrix 3 eingebracht.

Diese Fehlstellen-Zentren 4 sind in der Figur als Paare von Punkten angedeutet, welche die Verbindung der implementierten Ionen und Fehlstellen symbolisieren. Die Pfeile dieser Paare symbolisieren die von Null verschiedenen Spins der Fehlstellen-Zentren 4, mit welchen diese an den im folgenden geformten Spinpolarisationskanal 6 koppeln können.

In Fig. 1c und Fig. 1d wird das nach dem Einbringen der Fehlstellen-Zentren 4 erfolgende Aufwachsen einer C13 angereicherten Diamantschicht 5 gezeigt. Auch die Diamantschicht 5 wird mittels CVD aufgewachsen und weist nach dem Aufwachsen eine Dicke D von ca. 1 nm auf.

Ähnlich wie beim Aufwachsen der Diamantmatrix 3 wird als Wachstumsgas ein C12 haltiges Gas, insbesondere Methangas, genutzt. Jedoch ist dieses Wachstumsgas mit C13 angereichert. Daher ist auch die auf die Diamantmatrix 3 aufgewachsene Diamantschicht 5 mit C13 angereichert. Dies ermöglicht es, im Folgenden einen Spinpolarisationskanal 6 zu fertigen, welcher oberhalb der Fehlstellen-Zentren 4 angeordnet ist.

Durch die Anreicherung der Diamantschicht 5 mit C13 enthält diese C13-Atome, welche einen von Null verschiedenen Kernspin aufweisen. Die C13-Atome stehen damit im Gegensatz zu den übrigen kernspinlosen, d. h. einen Kernspin von Null aufweisenden, C12-Atomen der Diamantschicht 5. Mit diesem Kernspin können die C13-Atome an die Spins der Fehlstellen-Zentren 4 koppeln, wodurch ein Transport der Spinpolarisation ermöglicht wird. Die kernspinbehafteten C13-Atome sind in Fig. 1d als Punkte mit Pfeilen angedeutet, welche die Kernspins symbolisieren.

Dabei ist auch zu erkennen, dass die unter der Diamantschicht 5 angeordnete Diamantmatrix 3 weitestgehend keine kernspinbehafteten Diamantatome aufweist, da diese die kernspinlosen C12 umfasst. Einzig die Fehlstellen-Zentren 4 sind in der Diamantschicht 5 kernspinbehaftet. Eine Ausbreitung der Spinpolarisation ist ausgehend von den Fehlstellen-Zentren 4 in der Diamantmatrix 3 daher nicht möglich.

In der C13 angereicherten Diamantschicht 5 kann sich die Spinpolarisation jedoch in sämtliche Richtungen ausbreiten. Mit der in Fig. 1c und Fig. 1d gezeigten Diamantschicht 5 kann somit noch keine gerichtete Ausbreitung einer Spinpolarisation erzielt werden.

Um eine gerichtete Ausbreitung der Spinpolarisation zu ermöglichen, muss aus der Diamantschicht 5 ein Spinpolarisationskanal 6 geformt werden, wie in Fig. 1e gezeigt. Dabei wird die C13 angereicherte Diamantschicht 5 bereichsweise abgetragen, so dass nur der Spinpolarisationskanal 6 verbleibt.

Zu diesem Zwecke wird ein lithographisches ICP-Ätzverfahren eingesetzt. Jener Bereich der Diamantschicht 5, welcher den Spinpolarisationskanal 6 formen soll, wird dabei mit einem Fotolack beschichtet. Die derart maskierte Diamantschicht 5 kann dem Plasma 9 ausgesetzt werden. In den nicht maskierten Bereichen wird die C13 angereicherte Diamantschicht 5 auf diese Weise kontrolliert abgetragen.

Nach dem Abtragen verbleibt von der C13 angereicherten Diamantschicht 5 lediglich ein langer und dünner Spinpolarisationskanal 6 aus C13 angereichertem Diamant. Dieser Spinpolarisationskanal 6 weist im dargestellten Ausführungsbeispiel nach der Formung eine Breite B im Bereich von 5 nm bis 100 nm, eine Länge L im Bereich von ca. 5 nm bis 100 µm und eine Dicke D im Bereich von 0,5 nm bis 100 nm auf.

In dem Spinpolarisationskanal 6 sind weiterhin kernspinnbehaftete C13-Atome angeordnet. Da sich der Spinpolarisationskanal 6 oberhalb der Fehlstellen-Zentren 4 befindet und sich zwischen diesen erstreckt, ermöglicht er eine gerichtete Ausbreitung einer Spinpolarisation zwischen den beiden Fehlstellen-Zentren 4.

Wenngleich voranstehend die Herstellung eines einzelnen Spinpolarisationskanals 6 beschrieben wurde, können in gleicher Weise auch parallel mehrere Spinpolarisationskanäle 6 zwischen unterschiedlichen Fehlstellen-Zentren 4 der Diamantmatrix 3 hergestellt werden. So kann eine Spin-Informations-Transportvorrichtung 1 mit mehreren Spinpolarisationskanälen 6 auf derselben Diamantmatrix 3 erzeugt werden, um beispielsweise Quantentransistoren oder Qubit-Register zu erhalten.

In Fig. 1f wird gezeigt, wie die Spin-Informations-Transportvorrichtung 1 nach der Formung des Spinpolarisationskanals 6 zusätzlich mit einer C12-Diamantschutzschicht 7 versehen wird. Zu diesem Zwecke wird der Spinpolarisationskanal 6 mit der C12-Diamantschutzschicht 7 überdeckt.

Die C12-Diamantschutzschicht 7 wird in gleicher Weise wie die Diamantmatrix 3 mittels eines CVD-Verfahrens aufgewachsen. Als Basis für das Wachstum der C12-Diamantschutzschicht 7 dient der Spinpolarisationskanal 6 sowie jene Bereiche der Diamantmatrix 3, von denen die Diamantschicht 5 vollständig abgetragen wurde.

Zum Wachstum der C12-Diamantschutzschicht 7 wird ein C13-freies Wachstumsgas 8 genutzt, so dass die C12-Diamantschutzschicht 7 nach Abschluss des Wachstums kernspinlos ist.

Diese C12-Diamantschutzschicht 7 kann den Spinpolarisationskanal 6 vor negativen externen Einflüssen schützen und zur Steigerung der Kohärenzzeit der Fehlstellen-Zentren 4 beitragen. Dies wird erreicht, indem die C12-Diamantschutzschicht 7 C13-frei ist. Sie weist somit keine kernspinbehafteten Diamantatome auf, welche an die Spins der Fehlstellen-Zentren 4 oder des Spinpolarisationskanals 6 koppeln und sich so negativ auf die Kohärenzzeit auswirken könnten.

Zudem kann die C12-Diamantschutzschicht 7 als eine Schutzschicht zum Schutz des Spinpolarisationskanals 6 vor mechanischen Beschädigungen dienen.

Mit der C12-Diamantschutzschicht 7 kann eine Spin-Informations-Transportvorrichtung 1 bereitgestellt werden, welche im Vergleich zu einer diamantschutzschichtlosen Spin-Informations-Transportvorrichtung 1, wie sie in Fig. 1e dargestellt ist, noch stabiler und zuverlässiger ist.

Die C12-Diamantschutzschicht 7 weist eine Dicke S im Bereich von 50 nm bis 100 nm auf. Die C12-Diamantschutzschicht kann dabei genauso dick wie die Diamantmatrix 3 sein. Auf diese Weise wird der Spinpolarisationskanal 6 symmetrisch in der Mitte des Schichtsystems aus C12-Diamantschutzschicht 7 und Diamantmatrix 3 eingeschlossen und geschützt.

Mit Hilfe der vorstehend beschriebenen Spin-Informations-Transportvorrichtung 1 und dem Verfahren zur Herstellung dieser ist es möglich eine Vorrichtung bereitzustellen, mit welcher eine Spin-Information gerichtet transportiert werden kann.

### BEZUGSZEICHENLISTE

- 1: Spin-Informations-Transportvorrichtung
- 2: Diamantsubstrat
- 3: Diamantmatrix
- 4: Fehlstellen-Zentren
- 5: Diamantschicht
- 6: Spinpolarisationskanal
- 7: C12-Diamantschutzschicht
- 8: Wachstumsgas
- 9: Plasma
- B: Breite
- D: Dicke
- L: Länge
- M: Dicke
- S: Dicke
- W: Wachstumsrichtung

## Patentansprüche

1. Spin-Informations-Transportvorrichtung (1) umfassend eine Diamantmatrix (3) aus C12-Diamant und zwei Fehlstellen-Zentren (4), insbesondere NV-Zentren, innerhalb der Diamantmatrix (3), **gekennzeichnet durch** einen Spinpolarisationskanal (6), insbesondere aus C13 angereichertem Diamant, zur Ermöglichung einer gerichteten Ausbreitung einer Spinpolarisation, welcher sich zwischen den zwei Fehlstellen-Zentren (4) erstreckt.

2. Spin-Informations-Transportvorrichtung (1) nach Anspruch 1, **dadurch gekennzeichnet, dass** der Spinpolarisationskanal (6) oberhalb der Fehlstellen-Zentren (4) angeordnet ist.

3. Spin-Informations-Transportvorrichtung (1) nach einem der Ansprüche 1 oder 2, **dadurch gekennzeichnet, dass** der Spinpolarisationskanal (6) von einer C12-Diamantschutzschicht (7) überdeckt ist.

4. Spin-Informations-Transportvorrichtung (1) nach einem der vorhergehenden Ansprüche, **dadurch gekennzeichnet, dass** die Diamantmatrix (3) auf einem Diamantsubstrat (2) angeordnet ist.

5. Spin-Informations-Transportvorrichtung (1) nach einem der vorhergehenden Ansprüche, **dadurch gekennzeichnet, dass** der Spinpolarisationskanal (6) eine Breite (B) von 1 nm bis 10 µm, eine Länge (L) von mindestens 5 nm, bevorzugt mindestens 500 nm, insbesondere bevorzugt im Bereich von 500 nm bis 1 µm, und/oder eine Dicke (D) im Bereich von 0,5 nm bis 100 nm aufweist.

6. Spin-Informations-Transportvorrichtung (1) nach einem der vorhergehenden Ansprüche, **dadurch gekennzeichnet, dass** die Diamantmatrix (3) eine Dicke (M) von mindestens 50 nm, insbesondere mindestens 100 nm, aufweist.

7. Verfahren zur Herstellung einer Spin-Informations-Transportvorrichtung (1) umfassend die Schritte:
• Aufwachsen einer Diamantmatrix (3) aus C12 angereichertem Diamant auf ein, insbesondere ultrareines, Diamantsubstrat (2) mittels CVD;
• Einbringen von Fehlstellen-Zentren (4) in die Diamantmatrix (3);
• Aufwachsen einer C13 angereicherten Diamantschicht (5);
• bereichsweises Abtragen der C13 angereicherten Diamantschicht (5), insbesondere durch Ätzen, zur Formung eines Spinpolarisationskanals (6).

8. Verfahren nach Anspruch 7, **dadurch gekennzeichnet, dass** auf den Spinpolarisationskanal (6) eine C12-Diamantschutzschicht (7) zur Steigerung der Kohärenzzeit der Fehlstellen-Zentren (4) aufgewachsen wird.

9. Verfahren nach einem der Ansprüche 7 oder 8, **dadurch gekennzeichnet, dass** das Aufwachsen der C13 angereicherten Diamantschicht (5) mittels CVD unter Nutzung von C13-angereichertem Methangas erfolgt.

10. Verfahren nach einem der Ansprüche 7 bis 9, **dadurch gekennzeichnet, dass** das bereichsweise Abtragen der C13 angereicherten Diamantschicht (5) mittels eines kontrollierten Plasmaätzens, insbesondere ICP, der Oberfläche der C13 angereicherten Diamantschicht (5) erfolgt.
